Europäisches Patentamt

European Patent Office

Office européen des brevets

(19)

(11) Numéro de publication: **0 172 044**
**B1**

(12)

# FASCICULE DE BREVET EUROPEEN

(45) Date de publication du fascicule du brevet: **18.01.89**

(21) Numéro de dépôt: **85401176.4**

(22) Date de dépôt: **13.06.85**

(51) Int. Cl.⁴: **G 04 G 15/00**, G 05 B 19/04, H 03 K 17/296, D 06 F 33/02

(54) **Programmateur à horloge pour la commande d'un appareil d'usage domestique, notamment un lave-linge.**

(30) Priorité: **22.06.84 FR 8409876**

(43) Date de publication de la demande:
**19.02.86 Bulletin 86/08**

(45) Mention de la délivrance du brevet:
**18.01.89 Bulletin 89/03**

(84) Etats contractants désignés:
**AT BE CH DE FR GB IT LI LU NL SE**

(56) Documents cités:
FR-A-2 417 174
GB-A-2 051 427
US-A-3 774 056
US-A-4 104 542
US-A-4 127 823

ELECTRONIC ENGINEERING, vol. 55, no. 684, décembre 1983, pages 25,26, Londres, GB; H.R. GOODWIN: "Charge balancing frequency multiplier

(73) Titulaire: **CIAPEM**
**137, rue de Gerland**
**F-69007 - Lyon (FR)**

(72) Inventeur: **Delhomme, Bernard**
**THOMSON-CSF SCPI 173, bld Haussmann**
**F-75379 Paris Cedex 08 (FR)**
Inventeur: **Garofalo, François**
**THOMSON-CSF SCPI 173, bld Haussmann**
**F-75379 Paris Cedex 08 (FR)**
Inventeur: **Gas, Jean-Claude**
**THOMSON-CSF SCPI 173, bld Haussmann**
**F-75379 Paris Cedex 08 (FR)**

(74) Mandataire: **Grynwald, Albert et al**
**THOMSON-CSF SCPI 19, avenue de Messine**
**F-75008 Paris (FR)**

## Description

L'invention est relative à un programmateur à horloge pour la commande d'un appareil d'usage domestique.

La plupart des programmateurs de commande d'appareils d'usage domestique, tels que lave-linge, lave-vaisselle, sèche-linge ... imposent des cycles ou programmes de fonctionnement de durée invariable. Cette contrainte est favorable à la standardisation et donc à l'abaissement des coûts pour la fabrication en grande série. Mais elle constitue un inconvénient car elle limite les possibilités d'utilisation de l'appareil.

On pourrait envisager d'utiliser la technique connue par le brevet US 4 127 823 décrivant un programmateur correspondant au préambule de la revendication 1 et qui consiste à faire varier la sequence de temps en faisant varier la position de commutateurs. Mais une telle solution est onéreuse.

L'invention remédie à cet inconvénient. Elle permet d'augmenter les possibilités d'utilisation des appareils d'usage domestique avec un accroissement réduit du coût de fabrication.

Le programmateur selon l'invention est du type à horloge, c'est-à-dire à oscillateur de fréquence déterminée, de valeur standard, commandant le déroulement des programmes, le temps d'éxécution de chacun de ces derniers étant fonction de la fréquence. Il est caractérisé en ce qu'il comprend un moyen, distinct des commandes du programmateur proprement dit, pour conférer à la fréquence d'horloge une valeur différente de la valeur standard pendant tout ou partie du cycle de façon à modifier le temps d'exécution du programme par l'appareil.

Dans ce brevet US 4 127 823, un dispositif de commande programmable impose des séquences de temps grâce à un circuit d'horloge et des diviseurs, une telle séquence correspondant par exemple aux diverses séquences d'un lave-linge. Cependant, ce brevet ne montre ni ne suggère l'invention, à savoir que conformément à la revendication 1 on peut modifier le temps d'exécution du programme par modification de la fréquence d'horloge et non pas par les commandes du programmateur proprement dit. En effet, dans ce brevet, la durée des séquences est seulement déterminée par la position des commutateurs.

Si la fréquence du signal d'horloge est augmentée, supérieure à une valeur standard, le programme sera exécuté en un temps plus court. Cette disposition peut être utilisée dans un lave-linge lorsque le linge est en petite quantité et/ou est peu sale; de même une fréquence d'horloge augmentée, supérieure à la valeur standard, est utilisable dans un lave-vaisselle pour laver des quantités réduites de vaisselle et/ou des ustensiles peu sales.

Dans le cas du lave-linge la modification, notamment l'augmentation de fréquence, par exemple le doublement, est mise en oeuvre soit pendant tout le programme, soit pendant seulement une partie tels que le lavage, le prélavage et l'essorage.

La fréquence d'horloge peut également être inférieure à la fréquences standard pour augmenter la durée du programme et donc renforcer l'action de l'appareil. Cette augmentation de durée est utile par exemple pour laver du linge ou de la vaisselle trés sales.

La fréquence du signal d'horloge peut également être asservie à un paramètre de commande de la machine. Ainsi pour un lave-linge comportant des boutons ou touches de commande à la disposition de l'utilisateur pour l'affichage de la charge de linge et du degré de salissure, l'actionnement de ces boutons agit sur la fréquence d'horloge afin de conférer à la durée du cycle de lavage une durée qui est fonction de la charge et/ou du degré de salissure. Cette commande de variation de la fréquence d'horloge peut également être effectuée de façon automatique; par exemple si le lave-linge comporte un capteur délivrant un signal représentatif de la charge de linge introduite dans le tambour, ce signal est utilisé pour faire varier la fréquence d'horloge.

La variation de fréquence peut être obtenue de diverses manières. Dans une réalisation elle est obtenue par programmation du microprocesseur que comporte le programmateur. Mais si, comme c'est le cas le plus courant, la capacité de mémoire du microprocesseur est faible et si son nombre d'entrées et/ou sorties est insuffisant, on utilisera des circuits extérieurs au microprocesseur pour effectuer la variation de fréquence.

L'augmentation de la fréquence d'horloge peut non seulement être utilisée pour adapter le temps d'exécution du cycle de fonctionnement au produit traité par l'appareil, mais également, en cas de besoin, pour terminer plus rapidement un cycle sans arrêter complètement le fontionnement de l'appareil.

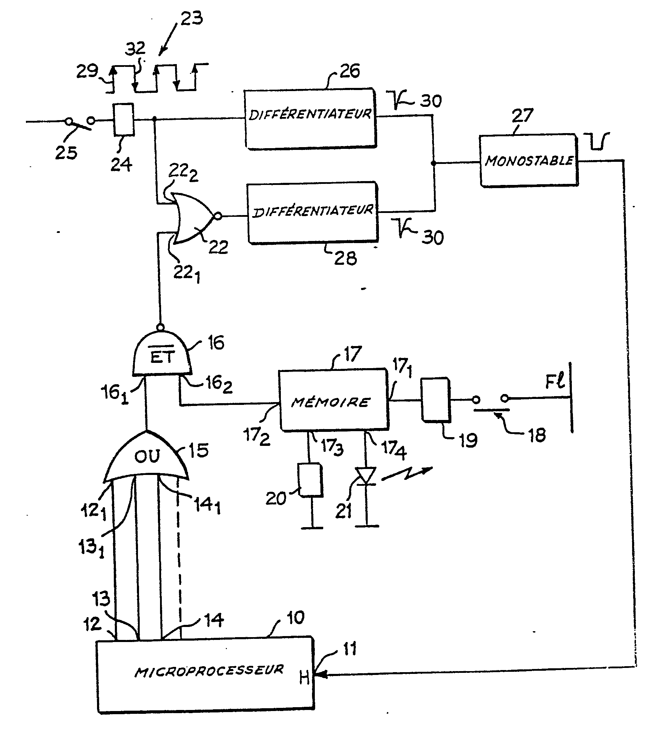

D'autres caractéristiques et avantages de l'invention apparaîtront avec la description de certains de ses modes de réalisation qui sera effectuée en se référant à la figure unique qui représente unprogrammateur de commande de lave-linge conforme à l'invention.

Le programmateur de lave-linge comporte, pour commander les diverses opérations à effectuer, de façon en soi connue, un microprocesseur 10 présentant une entrée d'horloge 11 sur laquelle est appliqué un signal d'horloge H ou base de temps.

Les opérations à commander sont notamment l'ouverture et la fermeture de l'électrovanne d'introduction d'eau, le fonctionnement de la pompe de vidange, la mise en route de l'essorage, etc ... C'est le programme implanté dans le microprocesseur qui détermine la succession des diverses opérations et leur temps de mise en oeuvre en fonction des données affichées par l'utilisateur : température de lavage, charge de linge, vitesse d'essorage, etc ...

Le temps d'exécution de chaque opération dépend (par exemple de façon linéaire) de la fréquence du signal d'horloge appliqué sur l'entrée 11.

Le microprocesseur 10 comporte des sorties 12, 13, 14, etc ... qui, dans l'exemple, sont reliées à des circuits interfaces (non représentés) pour la commande du prélavage, du lavage, des l'essorage, etc . . .

De plus, selon une disposition de l'invention, ces sorties 12, 13, 14, etc . . . sont reliées à des entrées respectivement $12_1$, $13_1$, $14_1$ . . . d'une OU 15 dont la sortie est connectée à la première entrée $16_1$ d'une porte ET-NON 16 dont la seconde entrée $16_2$ est reliée à la sortie d'un circuit mémoire 17 destiné à mémoriser une commande de programme écourté comme on le verra plus loin.

L'entrée $17_1$ de mémorisation du circuit 17 est connectée à un contacteur 18 à touche par l'intermédiaire d'un circuit 19 de mise en forme, par exemple un simple monostable. La fermeture de l'interrupteur à touche 18 permet la mémorisation, dans le circuit 17, de la commande de programme court. Le signal représentant cette commande apparaît alors en permanence sur la sortie $17_2$ reliée à l'entrée $16_2$ de la porte 16.

Le circuit 17 comporte une seconde entrée $17_3$ connectée à un circuit d'initialisation 20 permettant de positionner correctement la mémoire 17 lors de la mise en circuit. Cette mémoire 17 comporte en outre une seconde sortie $17_4$ à laquelle est reliée une diode électroluminescente 21 indiquant l'état de la mémoire 17. Dans un exemple la diode 21 est excitée quand un programme court a été commandé et éteinte dans le cas contraire; dans un autre exemple la diode 21 clignote, c'est-à-dire est alternativement excitée et non excitée, quand le lave-linge éxécute un programme et la fréquence de clignotement est plus importante lorsqu'un programme court est demandé que dans le cas contraire.

La sortie de la porte ET-NON 16 est reliée à la première entrée $22_1$ d'une porte OU-NON 22 dont la seconde entrée $22_2$ reçoit un signal rectangulaire 23 de rapport cyclique égal à ½ et de fréquence 50 Hz, fourni par un circuit de mise en forme 24 dont l'entrée reçoit le signal alternatif du réseau à la fréquence de 50 Hz par l'intermédiaire d'un interrupteur 25 ouvert quand la porte du lave-linge est ouverte et fermé quand la porte du lave-linge est fermée.

La sortie du circuit 24 est par ailleurs reliée à l'entrée d'un premier différentiateur 26 dont la sortie est connectée à l'entrée d'un monostable 27. L'entrée du monostable 27 est également reliée à la sortie d'un second différentiateur 28 dont l'entrée est reliée à la sortie de la porte OU-NON 22.

Les différentiateurs 26 et 28 sont identiques. Chacun d'eux est tel que le front de descente d'un signal appliqué sur son entrée provoque sur sa sortie l'apparition d'une impulsion 30.

Enfin la sortie du monostable 27 est connectée à l'entrée d'horloge 11 du microprocesseur 10.

Le fonctionnement est le suivant:

Si la touche 18 n'a pas été actionnée le signal sur la sortie $17_2$ de la mémoire 17 correspond au chiffre binaire 0. Il en résulte que le signal sur la sortie de la porte ET-NON 16 correspond au chiffre 1. La sortie de la porte OU-NON 22 est donc à 0 et le différentiateur 28 ne reçoit ainsi pas de signal. Seule l'entrée du différentiateur 26 reçoit le signal 23. Les impulsions 30 correspondent aux fronts de descente 32 du signal 23. Elles sont à la fréquence de 50 Hz. Dans ces conditions le signal appliqué sur l'entrée d'horloge 11 du microprocesseur 10 est également à la fréquence de 50 Hz. Ainsi le programme commandé par le microprocesseur 10 a la durée "standard".

Lorsqu'a été commandé un programme "accéléré" ou "court" par actionnement de la touche 18, sur la sortie $17_2$ de la mémoire 17 apparaît un signal correspondant à 1. Si en même temps l'une des sorties 12, 13, 14 . . . est également à 1, la sortie de la porte OU 15 est à 1 et il en de même pour l'entrée $16_1$ de la porte ET-NON 16. Il en résulte que la sortie de la porte 16 est à 0 et sur la sortie de la porte OU-NON 22 apparaît l'inverse du signal 23. Ainsi sur l'entrée du différentiateur 28 apparaît un front de descente 32 quand survient un front de montée du signal 23. Dans ces conditions au cours d'une alternance de signal alternatif du secteur à 50 Hz apparaissent deux impulsions 30, l'une correspondant au front 29 et l'autre au front 32. Le signal d'horloge appliqué sur l'entrée 11 du microprocesseur 10 est donc à la fréquence de 100 Hz.

Lorsque la sortie de la mémoire 17 est à 1 et la sortie de la porte OU 15 est à 0 la sortie de la porte 22 est à 0. La fréquence du signal d'horloge est dans ce cas de 50 Hz sur l'entrée 11. Autrement dit le programme n'est accéléré que lorsqu'un signal 1 de commande apparaît sur une des sorties 12, 13, 14 . . . du microprocesseur 10.

Avec l'exemple ainsi décrit, dont la réalisation est d'une grande simplicité, la sortie 12 commandant le prélavage, la sortie 13 le lavage et la sortie 14 l'essorage, le gain de temps est de 15 à 30 minutes sur la plupart des cycles de lavage lorsque la touche 18 est enfoncée. On notera ici qu'il n'est pas indispensable que toutes les sorties de commande d'opérations du microprocesseur 10 soient connectées aux entrées respectives de la porte OU 15; les opérations commandées par les sorties du microprocesseur non connectées à la porte OU ne seront ainsi pas affectées par l'actionnement de l'interrupteur 18. A titre d'exemple les opérations de pompage, pour la vidange de la cuve de la machine, n'ont pas leur durée affectée par l'actionnement du contact 18; il en est de même des phases d'accélération de la rotation du tambour lors de l'essorage.

La touche 18 peut être enfoncée à tout moment pendant l'exécution d'un programme de lavage. Si elle n'est pas enfoncée au début le gain de temps ne sera obtenu, bien entendu, que pour le reste du programme à exécuter.

Disposant d'un microprocesseur 10 déjà programmé il n'est pas nécessaire de modifier ce dernier ni sa programmation; il n'est pas nécessaire non plus d'utiliser d'entrée ou de sortie supplémentaire de ce microprocesseur.

En variante le doublement ou, de façon plus générale, la modification de la fréquence d'horloge est obtenu par une programmation du microprocesseur 10.

**Revendications**

1. Programmateur à horloge pour la commande d'un appareil d'usage ménager, le temps d'éxécution d'un cycle ou programme dépendant d'une fréquence d'horloge de valeur standard, caractérisé en ce qu'il comprend un moyen distinct des commandes du programmateur proprement dit pour conférer à la fréquence d'horloge une valeur différente de la valeur standard pendant tout ou partie du cycle de façon à modifier le temps d'éxécution du programme par l'appareil.

2. Programmateur selon la revendication 1, caractérisé en ce que pour réduire le temps d'exécution du cycle la fréquence d'horloge engendrée par ledit moyen (17-27) est supérieure à la fréquence d'horloge standard.

3. Programmateur selon la revendication 1, caractérisé en ce que pour augmenter le temps d'exécution du programme de fonctionnement de l'appareil, afin d'augmenter l'efficacité du traitement exécuté par l'appareil, la fréquence du signal d'horloge engendré par ledit moyen est inférieure à la fréquence standard.

4. Programmateur selon l'une quelconque des revendications 1 à 3, caractérisé en ce qu'il comporte un moyen pour asservir la fréquence d'horloge à au moins un paramètre de fonctionnement de l'appareil.

5. Programmateur selon l'une quelconque des revendications précédentes, caractérisé en ce que, comportant un microprocesseur (10) à entrée (11) d'horloge et sorties (12, 13, 14) de commande d'opérations, ledit moyen comporte des entrées $(12_1, 13_1, 14_1)$ connectées à au moins certaines sorties du microprocesseur pour que la fréquence d'horloge ne s'écarte de la valeur standard que lorsque des signaux de commande apparaissent sur lesdites sorties.

6. Programmateur selon la revendication 2, caractérisé en ce que la fréquence d'horloge délivrée par ledit moyen est le double de la fréquence standard.

7. Programmateur selon les revendications 5 et 6, caractérisé en ce qu'il comporte un circuit (24) pour engendrer un signal rectangulaire à la fréquence d'horloge standard et de rapport cyclique ½, un premier circuit (26) pour engendrer une impulsion (30) lors du front des descente (32) du signal rectangulaire et un second circuit (28) pour engendrer également une impulsion lors de l'apparition du front de montée (29) du signal rectangulaire (23) lorsqu'au moins un signal de commande apparaît sur l'une des sorties (12, 13, 14) du microprocesseur (10).

8. Programmateur selon la revendication 7, caractérisé en ce que lesdits circuits générateurs d'impulsions (30) comportent chacun un différentiateur (26, 28), les sorties de ces deux différentiateurs étant reliées a l'entrée d'horloge (11) du microprocesseur (10), de préférence par l'intermédiaire d'un monostable (27).

9. Programmateur selon la revendication 7 ou 8, caractérisé en ce qu'il comporte une porte OU (15) dont les entrées $(12_1, 13_1, 14_1)$ sont reliées auxdites sorties de commande (12, 13, 14) du microprocesseur (10), une porte ET-NON (16) dont une première entrée $(16_1)$ est reliée à la sortie de la porte OU (15) et une seconde entrée $(16_2)$ est connectée à la sortie d'un circuit (17) de mémorisation de la commande d'un programme court, et une porte OU-NON (22) dont la première entrée $(22_1)$ est reliée à la sortie de la porte ET-NON (16) et dont la seconde entrée $(22_2)$ reçoit ledit signal rectangulaire (23), la sortie de cette porte OU-NON (22) étant connectée à l'entrée du second circuit (28) générateur d'impulsion (30).

10. Programmateur selon l'une quelconque des revendications précédentes, caractérisé en ce qu'il comporte un moyen indicateur (21) que est excité lorsque la fréquence d'horloge s'écarte de la valeur standard.

11. Programmateur selon la revendication 10, caractérisé en ce que le moyen indicateur (21) est un indicateur lumineux clignotant, la fréquence de clignotement étant fonction de la fréquence d'horloge.

12. Programmateur selon la revendication 1, caractérisé en ce que, comportant un microprocesseur (10), la modification de la fréquence d'horloge est effectuée par la programme du microprocesseur (10).

13. Application de programmateur selon l'une quelconque des revendications précédentes, à la commande d'un lave-linge.

14. Programmateur selon la revendication 4 et destiné à la commande d'un lave-linge présentant des boutons ou touches de commande pour l'affichage de la charge de linge et du degré de salissure, caractérisé en ce que l'actionnement de ces boutons ou touches agit sur la fréquence d'horloge afin de conférer à la durée du cycle de lavage une valeur qui est fonction de la charge et/ou du degré de salissure.

15. Programmateur selon la revendication 4, destiné à commander un lave-linge, caractérisé en ce que le lave-linge comportant un capteur délivrant un signal représentatif de la charge de linge introduite dans le tambour, ce signal est utilisé pour faire varier la fréquence d'horloge.

16. Programmateur selon la revendication 1, caractérisé en ce que, comportant un microprocesseur (10), le moyen pour conférer à la fréquence d'horloge une valeur différente de la valeur standard est formé de circuits extérieurs au microprocesseur.

17. Programmateur selon la revendication 1 et destiné à la commande d'un lave-linge, caractérisé en ce qu'il comporte un organe (18) de commande dudit moyen qui est actionnable à volonté à tout moment pendant l'exécution du cycle de lavage.

18. Programmateur selon les revendications 5 et 17, caractérisé en ce que sorties de commande d'opérations du microprocesseur ne sont pas connectées à des entrées dudi moyen afin que la durée des opérations correspondantes ne soit pas affectée par l'actionnement du dispositif de commande (18).

19. Programmateur selon la revendication 18, caractérisé en ce que les opérations dont la durée n'est pas affectée par le dispositif de commande (18) du moyen de modification de la fréquence d'horloge comprennent les phases de vidange de la cuve de la machine et/ou les phases d'accélération de la rotation du tambour notamment au cours de l'essorage.

**Patentansprüche**

1. Taktgesteuertes Programmiergerät für die Steuerung eines Haushaltsgerätes, wobei die Ausführungszeit eines Zyklus bzw. eines Programms von Taktfrequenz mit einem Standardwert abhängig ist, dadurch gekennzeichnet, daß es eine Einrichtung umfaßt, die von den Steuerungen des eigentlichen Programmiergerätes getrennt ist, um der Taktfrequenz einen Wert zu verleihen, der von dem Standardwert während des gesamten Zyklus oder eines Teils desselben verschieden ist, so daß die Ausführungszeit des Programms durch das Gerät verändert wird.

2. Programmiergerät nach Anspruch 1, dadurch gekennzeichnet, daß, um die Ausführungszeit des Zyklus zu verringern, die von der genannten Einrichtung (17-27) erzeugte Taktfrequenz größer als die Standardtaktfrequenz ist.

3. Programmiergerät nach Anspruch 1, dadurch gekennzeichnet, daß, um die Ausführungszeit des Arbeitsprogramms des Gerätes zu erhöhen, damit die Wirksamkeit der von dem Gerät ausgeführten Behandlung erhöht wird, die Frequenz des durch die genannte Einrichtung erzeugten Taktsignals kleiner also die Standardfrequenz ist.

4. Programmiergerät nach einem der Ansprüche 1 bis 3, dadurch gekennzeichnet, daß es eine Einrichtung zur Nachregelung des Taktgebers durch wenigstens einen Betriebsparameter des Gerätes umfaßt.

5. Programmiergerät nach einem der vorstehenden Ansprüche, dadurch gekennzeichnet, daß die genannte Einrichtung einen Mikroprozessor (10) mit einem Takteingang (11) und mit Ausgängen (12, 13, 14) zur Steuerung der Arbeitsgänge sowie Eingänge ($12_1$, $13_1$, $14_1$) umfaßt, welche mit wenigstens bestimmten Ausgängen des Mikroprozessors verbunden sind, damit die Taktfrequenz erst dann von dem Standardwert abweicht, wenn Steuersignale an den genannten Ausgängen vorhanden sind.

6. Programmiergerät nach Anspruch 2, dadurch gekennzeichnet, daß die durch die genannte Einrichtung gelieferte Taktfrequenz doppelt so groß wie die Standardfrequenz ist.

7. Programmiergerät nach den Ansprüchen 5 und 6, dadurch gekennzeichnet, daß es eine Schaltung (24) zum Erzeugen eines Rechtecksignals mit der Standardtaktfrequenz, dessen Tastverhältnis $\frac{1}{2}$ beträgt, eine erste Schaltung (26) zum Erzeugen eines Impulses (30) während der Abfallflanke (32) des Rechtecksignals sowie eine zweite Schaltung (28) umfaßt, ebenfalls um bei dem Auftreten der Anstiegsflanke (29) des Rechtecksignals (23) einen Impuls zu erzeugen, wenn wenigstens ein Steuersignal an einem der Ausgänge (12, 13, 14) des Mikroprozessors (10) vorhanden ist.

8. Programmiergerät nach Anspruch 7, dadurch gekennzeichnet, daß jede der genannten Schaltungen zum Erzeugen der Impulse (30) einen Differenzierer (26, 28) umfaßt, wobei die Ausgänge dieser beiden Differenzierer mit dem Takteingang (11) des Mikroprozessors (10) vorzugsweise über eine monostabile Schaltung (27) verbunden sind.

9. Programmiergerät nach dem Anspruch 7 oder 8, dadurch gekennzeichnet, daß es eine OR-Schaltung (15) umfaßt, wovon die Eingänge ($12_1$, $13_1$, $14_1$) mit den genannten Steuerausgängen (12, 13, 14) des Mikroprozessors (10) verbunden sind, eine NAND-Schaltung (16) umfaßt, wovon ein erster Eingang ($16_1$) mit dem Ausgang der OR-Schaltung (15) und ein zweiter Eingang ($16_2$) mit dem Ausgang einer Schaltung (17) zum Speichern der Steuerung eines kurzen Programmes verbunden ist, sowie eine NOR-Schaltung (22) umfaßt, wovon der erste Eingang ($22_1$) mit dem Ausgang der NAND-Schaltung (16) verbunden ist sowie der zweite Eingang ($22_2$) das genannte Rechtecksignal (23) empfängt, wobei der Ausgang dieser NOR-Schaltung (22) mit dem Eingang der zweiten Schaltung (28) zum Erzeugen von Impulsen (30) verbunden ist.

10. Programmiergerät nach einem der vorstehenden Ansprüche, dadurch gekennzeichnet, daß es eine Anzeigeeinrichtung (21) umfaßt, welche erregt ist, wenn die Taktfrequenz von dem Standardwert abweicht.

11. Programmiergerät nach Anspruch 10, dadurch gekennzeichnet, daß die Anzeigeeinrichtung (21) eine blinkende Anzeige ist, wobei die Blinkfrequenz von der Taktfrequenz abhängt.

12. Programmiergerät nach Anspruch 1, dadurch gekennzeichnet, daß, da es einen Mikroprozessor (10) umfaßt, die Veränderung der Taktfrequenz durch das Programm des Mikroprozessors (10) durchgeführt wird.

13. Anwendung des Programmiergerätes nach einem der vorstehenden Ansprüche an die Steuerung einer Waschmaschine.

14. Programmiergerät nach Anspruch 4 für die Steuerung einer Waschmaschine bestimmt, welche Knöpfe oder Steuertasten für die Anzeige der Wäscheladung und des Verschmutzungsgrades aufweist, dadurch gekennzeichnet, daß die Betätigung dieser Knöpfe bzw. Tasten auf die Taktfrequenz einwirkt, um der Wäschezyklusdauer einen Wert zu verleihen, der von der Ladung und/oder dem Verschmutzungsgrad abhängig ist.

15. Programmiergerät nach Anspruch 4 für die Steuerung einer Waschmaschine bestimmt, dadurch gekennzeichnet, daß die Waschmaschine eine Meßfühler umfaßt, dessen Signal für die in die Trommel eingeführte Wäscheladung repräsentativ ist, und daß dieses Signal für die Veränderung der Taktfrequenz verwendet wird.

16. Programmiergerät nach Anspruch 1, dadurch gekennzeichnet, daß die mit einem Mikroprozessor (10) versehene Einrichtung, die der Taktfrequenz einen von dem Standardwert verschiedenen Wert verleiht, durch Schaltungen gebildet ist, welche außerhalb des Mikroprozessors gelegen sind.

17. Programmiergerät nach Anspruch 1, für die Steuerung einer Washmaschine bestimmt, dadurch gekennzeichnet, daß es ein Element (18) zur Steuerung der genannten Einrichtung umfaßt, welches während der Ausführung des Waschzyklus jederzeit beliebig betätigt werden kann.

18. Programmiergerät nach den Ansprüchen 5 und 17, dadurch gekennzeichnet, daß die Ausgänge zur Steuerung der Arbeitsgänge des Mikroprozessors nicht mit Eingängen der genannten Einrichtung verbunden sind, damit die Dauer der entsprechenden Arbeitsgänge durch die Betätigung der Steuervorrichtung (18) nicht berührt wird.

19. Programmiergerät nach Anspruch 18, dadurch gekennzeichnet, daß die Arbeitsgänge, deren Dauer von der Steuervorrichtung (18) der Einrichtung zur Veränderung der Taktfrequenz nicht berührt ist, die Schritte der Entleerung der Waschmaschinenwanne und/oder die Schritte der Beschleunigung der Trommeldrehung insbesondere während des Schleuderns umfassen.

**Claims**

1. A clock programming device for the operation of a household apparatus, the time of execution of a cycle or of a program being dependent on the frequency of a standard value clock, characterized in that it comprises a distinct programming control means properly so called in order to confer on the clock frequency a value different to the standard value during all or part of a cycle in such a manner as to modify the time of execution of the program by the apparatus.

2. The programming device as claimed in claim 1, characterized in that in order to reduce the time of execution of the cycle the clock frequency produced by the said means (17 to 27) is greater than the standard clock frequency.

3. The programming device as claimed in claim 1 characterized in that in order to augment the time of execution of the program of the function of the apparatus, in order to improve the efficiency of the treatment performed by the apparatus, the clock signal frequency produced by the said means is lower than the standard frequency.

4. The programming device as claimed in any one of claims 1 through 3, characterized in that it comprises means to vary the clock frequency in accordance with at least one parameter of the operation of the apparatus.

5. The programming device as claimed in any one of the preceding claims, characterized in that, comprising a microprocessor (10) and the input (11) of the clock and outputs (12, 13 and 14) of control of operations, the said means comprises inputs ($12_1$, $13_1$ and $14_1$) connected to at least specific ones of the outputs of the microprocessor in order to ensure that the frequency of the clock only differs from the standard value when control signals appear at the said outputs.

6. The programming device as claimed in claim 2, characterized in that the clock frequency delivered by the said means is double the standard frequency.

7. The programming device as claimed in claims 5 and 6, characterized in that it comprises a circuit (24) to produce a rectangular signal at the standard clock frequency and with a cycle ratio of ½, a first circuit (26) to produce a pulse (30) at the time of the appearance of the descending flank (32) of the rectangular signal and a second circuit to similarly produce a pulse on the appearance of the ascending flank (29) of the rectangular signal (23) when at least one control signal appears at one of the outputs (12, 13 and 14) of the microprocessor (10).

8. The programming device as claimed in claim 7, characterized in that the said circuits (30) for the generation of pulses (30) each comprise a differentiator (26 and 28), the outputs of these two differentiators being connected with the clock input (11) of the microprocessor (10), preferably by the intermediary of a monostable multivibrator (27).

9. The programming device as claimed in claims 7 or claim 8, characterized in that it comprises an OR gate (15), whose inputs ($12_1$, $13_1$, and $14_1$) are connected with the said control outputs (12, 13 and 14) of the microprocessor (10), and AND—NOT gate (16), whose one first input ($16_1$) is connected with the output of the OR gate (15) and a second input ($16_2$) is connected with the output of a circuit (17) for storing the control of a short program, and an an OR—NOT gate (22) whose first input ($22_1$) is connected with the output of the AND—NOT gate (16) and whose second input ($22_2$) is connected with the output of the AND—NOT gate (16) and whose second output ($22_2$) receives the said rectangular signal (23), the output of this OR—NOT gate (22) being connected with the input of the second circuit (28) generating a pulse (30).

10. The programming device as claimed in any one of the preceding claims, characterized in that it comprises an indicating means (21) which is excited when the clock frequency differs from the standard value.

11. The programming device as claimed in claim 10, characterized in that the indicating means (21) is a flashing light indicator, the flash frequency being a function of the clock frequency.

12. The programming device as claimed in claim 1, characterized in that, comprising a microprocessor (10), the modification of the clock frequency is effected by the microprocessor (10).

13. The application of the programming device as claimed in any one of the preceding claims to the control of a washing machine.

14. The programming device as claimed in claim 4 intended for the control of a washing machine having control buttons or keys for indicating the amount of material to be washed and the degree of soiling, characterized in that the operation of these buttons or keys takes effect on the clock frequency in order to confer on the duration of the cycle a value which is a function of the amount and/or the degree of soiling.

15. The programming device as claimed in claim 4, intended for the control of a washing machine, characterized in that the washing machine comprising a sensor providing a signal representing the amount of washing placed in the drum of the washing machine, this signal is utilized in order to vary the frequency of the clock.

16. The programming as claimed in claim 1, characterized in that, comprising a microprocessor (10), the means to confer on the clock frequency a value different from the standard value is constituted by circuits external of the microprocessor.

17. The programming device as claimed in claim 1 and intended for the control of a washing machine, characterized in that it comprises a device (18) for the control of the said means which is able to be actuated at will at any time during the execution of the wash cycle.

18. The programming device as claimed in claims 5 and 17, characterized in that the operation control outputs of the microprocessor are not connected with inputs of the said means in order to ensure that the duration of the corresponding operations are is not affected by the actuation of the control device (18).

19. The programming device as claimed in claim 18, characterized in that the operations whose duration is not affected by the control device (18) of the means for modification of the clock frequency comprise tube emptying phases for the machine and/or rotation acceleration phases for the drum thereof, more especially during spinning.